# EUROPEAN PATENT APPLICATION

(11) **EP 4 300 563 A1**
(43) Date of publication of application: **03.01.2024**
(21) Application number: 22181977.4
(22) Date of filing: 29.06.2022
(51) Int. Cl.: H01L 21/8238, H01L 27/092, H01L 29/06

(54) **A MULTI-GATE HYBRID-CHANNEL FIELD EFFECT TRANSISTOR**

(71) Applicant: Huawei Technologies Co., Ltd., Shenzhen, Guangdong 518129 (CN)
(72) Inventor: CHEN, Yijian, Zhangzhou 363000 (CN); BHUWALKA, Krishna Kumar, 80992 Munich (DE)
(74) Representative: Roth, Sebastian

(57) **Abstract**

The present disclosure relates to a multi-gate hybrid-channel field effect transistor (FET) structure (100). The FET structure may be used to fabricate an integrated device like a nanosheet device or forksheet device. The FET structure comprises a substrate layer (101), a first layer stack (102) and a second layer stack (103) arranged side by side on the substrate layer, a first (106) and second (107) additional semiconductor channel layer arranged respectively besides the second layer stack, and a dielectric wall (108) arranged on the substrate layer between the first layer stack and the second layer stack. The first and second layer stack each comprise one or more semiconductor channel layers and gate layers stacked alternatingly with respective surfaces parallel to the surface of the substrate layer. Respective surfaces of the first and second additional semiconductor channel layer are parallel to each other and perpendicular to the surface of the substrate layer.

## Description

### TECHNICAL FIELD

The present disclosure relates to field effect transistors (FETs) and methods for making FETs. The disclosure presents a multi-gate hybrid-channel FET structure. The FET structure may be used to fabricate an integrated device like a nanosheet device or forksheet device.

### BACKGROUND

An integrated device comprising a FET structure, can be provided with an improved device performance by increasing an effective transistor width. This can be achieved by using a stack of a plurality of semiconductor channel layers for forming the FET structure. The effective transistor width depends on the channel widths and channel heights of each of the channel layers, and depends on the total number of channel layers that are used.

Accordingly, one way to increase the effective transistor width is to increase the number of channel layers. However, this number is limited by the efficiency of the bottom-most channel layer. This is due to the fact that a gradually decreased voltage across the lower channel layers and consequently lower current along these layers can be observed.

### SUMMARY

This disclosure aims to increase the effective transistor width in a FET structure and/or integrated device in a different way. For instance, the disclosure aims for a better effective width as in a three-gate forksheet like device. Thus, the disclosure aims for improved device performance.

This is achieved by the solutions of this disclosure as described in the independent claims. Advantageous implementations are defined in the dependent claims.

A first aspect of this disclosure provides a FET structure for a nanosheet device, the FET structure comprising: a substrate layer; a first layer stack and a second layer stack arranged side by side on the substrate layer, wherein the first layer stack and the second layer stack each comprise one or more semiconductor channel layers and one or more gate layers, which are stacked in an alternating manner along a first direction perpendicular to a surface of the substrate layer, wherein respective surfaces of the semiconductor channel layers and the gate layers are parallel to the surface of the substrate layer; at least a first additional semiconductor channel layer arranged besides the first layer stack and a second additional semiconductor channel layer arranged besides the second layer stack, wherein respective surfaces of the first additional semiconductor channel layer and the second additional semiconductor channel layer are parallel to each other and perpendicular to the surface of the substrate layer; and a dielectric wall arranged on the substrate layer between the first layer stack and the first additional semiconductor channel layer on the one side, and the second layer stack and the second additional semiconductor channel layer on the other side.

The first and second additional semiconductor channel layers may each be a fin-like structure that extend along the first direction, for instance, each may be a vertical fin. For example, each additional semiconductor channel layer may have a high aspect ratio of its extension into the first direction (layer length/height) compared to its extension into a second direction perpendicular to the first direction (layer thickness). The additional semiconductor channel layers allow increasing the effective transistor width in each layer stack. For example, the possible total width gain may be 2^{∗}n^{∗}Vp, wherein n is the number of semiconductor channel layers in a layer stack, and Vp is the pitch of these channel layers in the layer stack, which are stacked along the first direction (with gate layers arranged in between). The additional semiconductor channel layers can be provided within a gap between the first layer stack and the second layer stack, which is sufficiently large, so that the space consumed by the additional semiconductor channel layers may be negligible. The FET structure of the first aspect may provide a current gain, and may improve a device performance of an integrated device, in which it is used.

In an implementation form of the first aspect, the first additional semiconductor channel layer adjoins the first layer stack; and/or the second additional semiconductor channel layer adjoins the second layer stack.

Thus, the least amount of space in between the two layer stacks is consumed.

In an implementation form of the first aspect, the FET structure further comprises a third additional semiconductor channel layer arranged besides the first layer stack on the other side of the first layer stack than the first additional semiconductor channel layer; a fourth additional semiconductor channel layer arranged besides the second layer stack on the other side of the second layer stack than the second additional semiconductor channel layer; wherein the dielectric wall is arranged between the first layer stack, the first additional semiconductor channel layer, and the third additional semiconductor channel layer on the one side, and the second layer stack, the second additional semiconductor channel layer, and the fourth additional semiconductor channel layer on the other side.

This may further increase the effective transistor channel width, and thus the current gain.

In an implementation form of the first aspect, the third additional semiconductor channel layer adjoins the first layer stack; and/or the fourth additional semiconductor channel layer adjoins the second layer stack.

In this way, a compact FET structure can be achieved.

In an implementation form of the first aspect, each additional semiconductor channel layer is distanced from the layer stack, besides which it is arranged.

In an implementation form of the first aspect, the first layer stack and the first additional semiconductor channel layer form an n-type FET (n-FET); and/or the second layer stack and the second additional semiconductor channel layer form a p-type FET (p-FET).

In an implementation form of the first aspect, each additional semiconductor channel layer arranged besides the first layer stack is made of an n-type silicon-based semiconductor material; and/or each additional semiconductor channel layer arranged besides the second layer stack is made of a p-type silicon-based semiconductor material.

In an implementation form of the first aspect, each additional semiconductor channel layer comprises one or more sections made of silicon and one or more sections made of silicon germanium.

This silicon and silicon germanium heterostructure of the additional semiconductor channel layers may lead to more current gain due to the higher mobility of the silicon germanium.

In an implementation form of the first aspect, the one or more sections made of silicon of each additional semiconductor channel layer are respectively arranged besides the one or more semiconductor channel layers of the layer stack, besides which the additional semiconductor channel layer is arranged.

In an implementation form of the first aspect, the one or more gate layers of the first layer stack are made of an n-type work function metal; the one or more gate layers of the second layer stack are made of a p-type work function metal.

In an implementation form of the first aspect, the FET structure further comprises: a first gate all around (GAA) structure that surrounds the first layer stack and each additional semiconductor channel layer arranged besides the first layers stack, wherein the one or more gate layers of the first layer stack are formed integral with the first GAA structure; and/or a second GAA structure that surrounds the second layer stack and each additional semiconductor channel layer arranged besides the second layer stack, wherein the one or more gate layers of the second layer stack are formed integral with the second GAA structure.

Such GAA structures are beneficial for fabricating integrated devices, for instance, nanosheet devices or forksheet devices using the FET structure of the first aspect.

In an implementation form of the first aspect, the FET structure further comprises a dielectric material arranged on the substrate layer and enclosing the first layer stack, the second layers stack, each additional semiconductor channel layer, each GAA structure, and the dielectric wall.

In an implementation form of the first aspect, the first layer stack, each additional semiconductor channel layer arranged besides the first layer stack, and the first GAA structure form an n-FET structure; and the second layer stack, each additional semiconductor channel layer arranged besides the second layer stack, and the second GAA structure form a p-FET structure.

A second aspect of this disclosure provides a nanosheet device comprising the FET structure according to the first aspect or any of its implementation forms.

Due to the FET structure of the first aspect included in the integrated device, the integrated device may have an improved device performance.

A third aspect of this disclosure provides a method for fabricating a FET structure for a nanosheet device, the method comprising: forming a substrate layer; forming a first layer stack and a second layer stack side by side on the substrate layer; wherein the first layer stack and the second layer stack each comprise one or more semiconductor channel layers and one or more gate layers, which are stacked in an alternating manner along a first direction perpendicular to a surface of the substrate layer; wherein respective surfaces of the semiconductor channel layers and the gate layers are parallel to the surface of the substrate layer; forming at least a first additional semiconductor channel layer besides the first layer stack and a second additional semiconductor channel layer besides the second layer stack, wherein respective surfaces of the first additional semiconductor channel layer and the second additional semiconductor channel layer are parallel to each other and perpendicular to the surface of the substrate layer; and forming a dielectric wall on the substrate layer between the first layer stack and the first additional semiconductor channel layer on the one side and the second layer stack and the second additional semiconductor channel layer on the other side.

The method of the third aspect may have implementation forms according to the implementation forms of the FET structure of the first aspect, particularly, each the implementation forms of the method may form the implementation forms of the FET structure. Accordingly, the method of the third aspect and its potential implementation forms achieve the same advantages as the FET structure of the first aspect and its respective implementation forms.

### BRIEF DESCRIPTION OF DRAWINGS

The above described aspects and implementation forms will be explained in the following description of specific embodiments in relation to the enclosed drawings, in which:
- FIG. 1: shows a FET structure according to this disclosure.
- FIG. 2: shows different examples of a FET structure according to this disclosure.
- FIG. 3: shows a first exemplary process for fabricating a FET structure according to this disclosure.
- FIG. 4: shows a second exemplary process for fabricating a FET structure according to this disclosure.
- FIG. 5: shows a third exemplary process for fabricating a FET structure according to this disclosure.
- FIG. 6: shows a fourth exemplary process for fabricating a FET structure according to this disclosure.
- FIG. 7: shows a fifth exemplary process for fabricating a FET structure according to this disclosure.
- Fig. 8: shows a sixth exemplary process for fabricating a FET structure according to this disclosure.
- FIG. 9: shows a general method for fabricating a FET structure according to this disclosure.

### DETAILED DESCRIPTION OF EMBODIMENTS

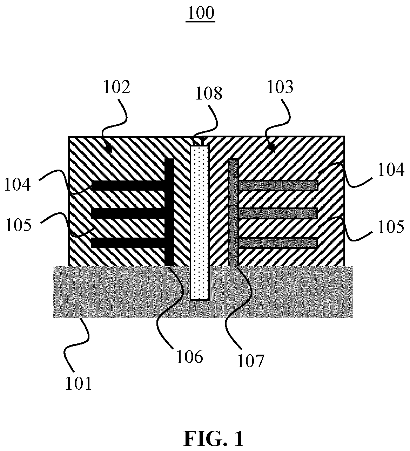

FIG. 1 shows a FET structure 100 according to this disclosure. The FET structure 100 may be used as a basis for building an integrated device. The integrated device may be, for example, a nanosheet device, or a forksheet device, or a complementary FET device, or the like.

The FET structure 100 comprises a substrate layer 101, which may be a semiconductor substrate layer, for example, a silicon-based or silicon layer. The substrate layer 101 may be provided on or by a thick substrate or a wafer.

The FET structure 100 further comprises a first layer stack 102 and a second layer stack 103, which are arranged side by side on the substrate layer 101. Thereby, the first layer stack 102 is separated from the second layer stack 103 by a certain distance (in a second direction). Accordingly, the first layer stack 102 is distanced from the second layer stack 103, and/or a gap is formed between the first layer stack 102 and the second layer stack 103.

Both the first layer stack 102 and the second layer stack 103 comprises one or more semiconductor channel layers 104 (e.g., silicon layers) and one or more gate layers 105 (e.g., metal layers and dielectric layers), which are stacked in an alternating manner along a first direction, wherein the first direction is perpendicular to a surface of the substrate layer 101 and the second direction (note, the first direction may also be referred to as stacking direction or growth direction if the layers 104, 105 are grown, for instance, by epitaxy). Respective surfaces of the semiconductor channel layers 104 and the gate layers 105 are parallel to the surface of the substrate layer 101 and to each other.

The FET structure 100 also comprises at least a first additional semiconductor channel layer 106 (e.g., a silicon layer), which is arranged besides the first layer stack 102, and at least a second additional semiconductor channel layer 107 (e.g., a silicon layer), which is arranged besides the second layer stack 103. Respective surfaces of the first additional semiconductor channel layer 106 and the second additional semiconductor channel layer 107 are parallel to each other and perpendicular to the surface of the substrate layer 101. The additional semiconductor channel layers 106, 107 may thus form fin-like structures, which extend along the first direction as illustrated, and may have a layer thickness measured along the second direction.

The FET structure 100 further comprises a dielectric wall 108 (e.g., made of silicon oxide), which is arranged on the substrate layer 101. The dielectric wall 108 is located between the first layer stack 102 and the first additional semiconductor channel layer 106 on the one side of the dielectric wall 108, and the second layer stack 103 and the second additional semiconductor channel layer 107 on the other side of the dielectric wall 108. Thus, the dielectric wall 108 is arranged between the first layer stack 102 and the second layer stack 103, for instance, in the gap between the two layer stacks 102, 103.

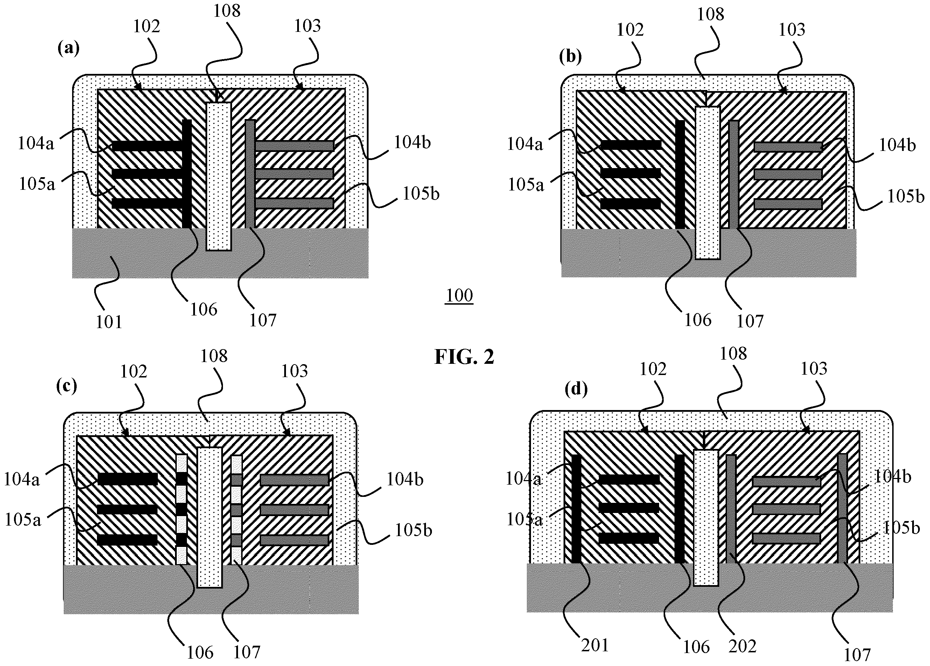

Generally, the first layer stack 102 and the first additional semiconductor channel layer 106 of the FET structure 100 of this disclosure may form an n-FET, while the second layer stack 103 and the second additional semiconductor channel layer 107 may form a p-FET. This will be shown, for instance, in FIG. 2. In this case, the one or more gate layers 105 of the first layer stack 102 may be made of an n-type work function metal 105a, while the one or more gate layers 105 of the second layer stack 103 may be made of a p-type work function metal 105b. Moreover, the semiconductor channel layers 104 of the first layer stack 102 may be undoped or p-type channel layers 104a, while the semiconductor channel layers 104 of the second layer stack 103 may be undoped or n-type channel layers 105b. Moreover, the first additional semiconductor channel layer 106 arranged besides the first layer stack 102 may be made of an undoped or p-type semiconductor material, and the second additional semiconductor channel layer 107 arranged besides the second layer stack 103 may be made of an undoped or n-type semiconductor material. Conventional semiconducting materials, like silicon-based or III-V, and conventional dopants for these semiconducting materials can be used to obtain the above-mentioned n-type and p-type FETs, respectively.

FIG. 2 shows different examples of a FET structure 100 according to this disclosure. In each example of FIG. 2, the first layer stack 102 and the first additional semiconductor channel layer 106 are used - as described above - to form an n-FET, and the second layer stack 103 and the second additional semiconductor channel layer 107 are used to form a p-FET.

In the example of FIG. 2a, the first additional semiconductor channel layer 106 adjoins the first layer stack 102, and the second additional semiconductor channel layer 107 adjoins the second layer stack 103. The dielectric wall 108 is formed, as an example, by a dielectric material that surrounds completely the layer stacks 102, 103, and also the additional semiconductor channel layers 106, 107.

In the example of FIG. 2b, the first additional semiconductor channel layer 106 is not adjoining the first layer stack 102 (but is distanced from the first layer stack 102), and the second additional semiconductor channel layer 107 is not adjoining the second layer stack 103 (but is distanced from the second layers stack 103). The dielectric wall 108 is again formed, as an example, by a dielectric material that surrounds the layer stacks 102, 103, and also the additional semiconductor channel layers 106, 107.

In the example of FIG. 2c, the first additional semiconductor channel layer 106 and the second additional semiconductor channel layer 107 each comprise one or more sections that are made of a first semiconductor material (e.g., of silicon) and one or more sections made of a second semiconductor material (e.g., of silicon germanium). These different sections and semiconducting materials may be alternatingly arranged along the first direction. For example, the sections of the first semiconductor material of each additional semiconductor channel layer 106, 107 may be respectively arranged besides the one or more semiconductor channel layers 104 of the layer stack 102, 103, besides which the additional semiconductor channel layer 106, 107 is arranged. The sections of the second semiconductor material of each additional semiconductor channel layer 106, 107 may be respectively arranged besides the one or more gate layers 105 of the layer stack 102, 103, besides which the additional semiconductor channel layer 106, 107 is arranged. The dielectric wall 108 is again formed, as an example, by a dielectric material that surrounds the layer stacks 102, 103, and also the additional semiconductor channel layers 106, 107.

In the example of FIG. 2d, the FET structure 100 further comprises a third additional semiconductor channel layer 201, which is arranged besides the first layer stack 102 on the other side of the first layer stack 102 than the first additional semiconductor channel layer 106. In addition, the FET structure 100 comprises a fourth additional semiconductor channel layer 202, which is arranged besides the second layer stack 102 on the other side of the second layer stack 102 than the second additional semiconductor channel layer 107. The dielectric wall 108 is arranged between the first layer stack 102, the first additional semiconductor channel layer 106, and the third additional semiconductor channel layer 201 on the one side of the dielectric wall 108, and the second layer stack 103, the second additional semiconductor channel layer 107, and the fourth additional semiconductor channel layer 202 on the other side of the dielectric wall 108. The dielectric wall 108 may be formed by a dielectric material (e.g., an oxide) that surrounds the layer stacks 102, 103, and the additional semiconductor channel layers 106, 107. Further, in FIG. 2d, all the additional semiconductor channel layers 106, 107, 201, 202 are shown exemplarily as being not adjoining the layer stack 102, 103, besides which they are arranged. However, each additional semiconductor channel layer 106, 107, 201, 202 could, individually, i.e., regardless of the others, be also adjoining the laser stack 102, 203, besides which it is arranged. That is, each layer stack 102, 103 may have no, one, or two adjoining additional semiconductor channel layers 106, 107, 201, 202. The same is true for the FET structure 100 in FIG. 2c.

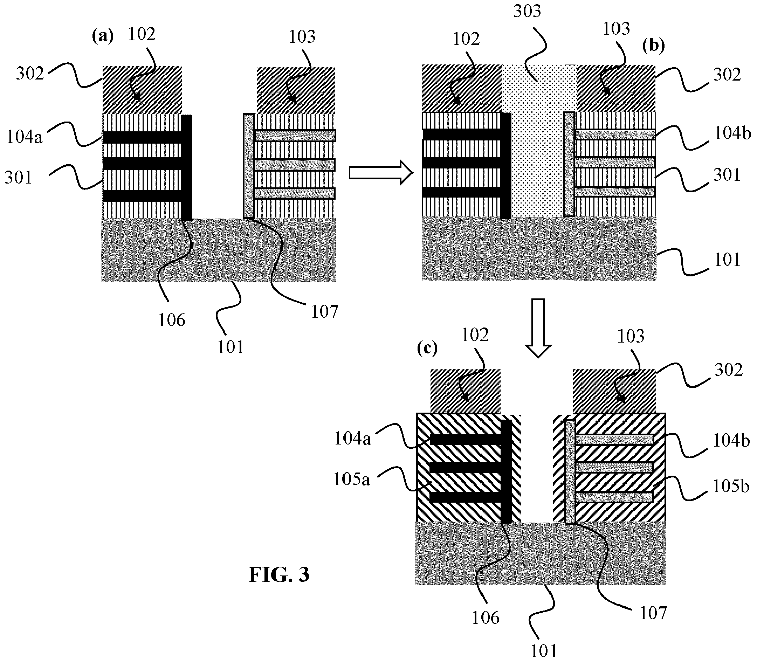

FIG. 3 shows a first exemplary process for fabricating a FET structure 100 according to this disclosure. In this case the FET structure 100 includes one additional semiconductor layer 106, 107 (fin) per layer stack 102, 103, where each additional semiconductor layer 106, 107 adjoins the layer stack 102, 103, besides which it is arranged. The process of FIG. 3 may thus be used to form the FET structure 100 of FIG. 2a.

FIG. 3a shows that initially the first layer stack 102 and the second layer stack 103 are fabricated on the substrate layer 101. For example, each layer stack 102, 103 may be epitaxially grown on the substrate layer 101. Thereby, a gap can be formed between the first layer stack 102 and the second layer stack 103. It is also possible, however, to grow one larger layer stack and then separate this larger layer stack into the first layer stack 102 and the second layer stack 103, for instance, by etching a trench. This can be done by using a hardmask 302 as illustrated. Notably, the semiconductor channel layers 104 can be the same for the first layer stack 102 and the second layer stack 103, i.e., of the same semiconductor material (e.g., silicon). However, as indicated by the different shadings in FIG. 3, they may be n-type channel layers 104a and p-type channel layers 104b, respectively. This can be achieved by different doping profiles of the semiconductor material.

Notably, at this point of the process (i.e., as shown in Fig. 3a), each layer stack 102 and 103 is an intermediate layer stack, as it comprises the semiconductor channel layers 104 (e.g., made of silicon), and semiconductor dummy gate layers 301 (e.g., made of silicon germanium) instead of the gate layers 105 shown in FIG. 1 and 2. However, this disclosure refers to the first layer stack 102 and the second layer stack 103, for reasons of simplicity, regardless of whether the gate layers 105 or the dummy gate layers 301 are present.

FIG. 3a further shows that the first additional semiconductor channel layer 106 and the second additional semiconductor channel layer 107 may be laterally grown, for instance, by lateral epitaxy, onto the sidewalls of the first layer stack 102 and the second layer stack 103, respectively. This is possible because of the gap between the layer stacks 102, 103.

FIG. 3b shows that a dielectric protection 303 can then be inserted in between the two layer stacks 102, 103, specifically, into the gap separating the two layer stacks 102, 103. For instance, the dielectric protection 303 may be formed by dielectric deposition.

FIG. 3c shows that the semiconductor dummy gate layers 301 may then be replaced by the gate layers 104 (e.g., metal). This can be done by selective etching of the dummy gate layers 301 (e.g., made of silicon germanium), and subsequent deposition of agate material, like a metal material, to form the gate layers 105. Different gate layers 105a, 105b may be formed for the two layer stacks 102, 103 by using different metal materials in the deposition step, for instance, an n-type work function metal for the first layer stack 102, and a p-type work function metal for the second layer stack 103. The dielectric protection 303 is also removed, and (not shown) finally, the dielectric wall 108 may be filled into the space between the two layer stacks 102, 103 formed by removing the dielectric protection 303. The dielectric protection 303 may also remain to form the dielectric wall 108.

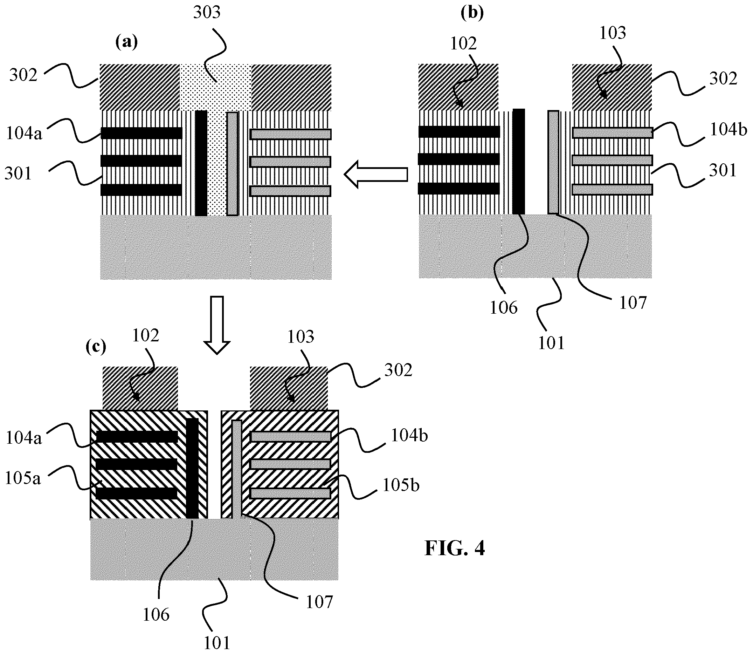

FIG. 4 shows a second exemplary process for fabricating a FET structure 100 according to this disclosure. In this case the FET structure 100 includes one additional semiconductor layer 106, 107 (e.g., fin) per layer stack 102, 103, where each additional semiconductor layer 106, 107 is not adjoining the layer stack 102, 103, besides which it is arranged. The process of FIG. 4 may thus be used to form the FET structure 100 of FIG. 2b.

The process of FIG. 4 is similar to the one shown in FIG. 3, however, it starts in FIG. 4a already with the dielectric protection 303 arranged between the two layer stacks 102, 103.

In FIG. 4b, the dielectric protection 303 is removed, and the first additional semiconductor channel layer 106 and the second semiconductor channel layer 107 are formed, for instance, by lateral epitaxy. Notably, the lateral epitaxy can be made directly on the material of the semiconductor dummy gate layers 301 (e.g., silicon germanium), which may extend beyond the channel layers 104 into the gap between the layer stacks 102, 103, so that the additional semiconductor channel layers 106 and 107 are later not adjoining the layer stacks 102, 103 (particularly not adjoining the channel layers 104), besides which they are arranged.

In FIG. 4c, the gate layers 104 are formed by replacing the semiconductor dummy gate layers 301 by e.g. at least one metal material. The dielectric wall 108 may be filled into the space between the two layer stacks 102, 103.

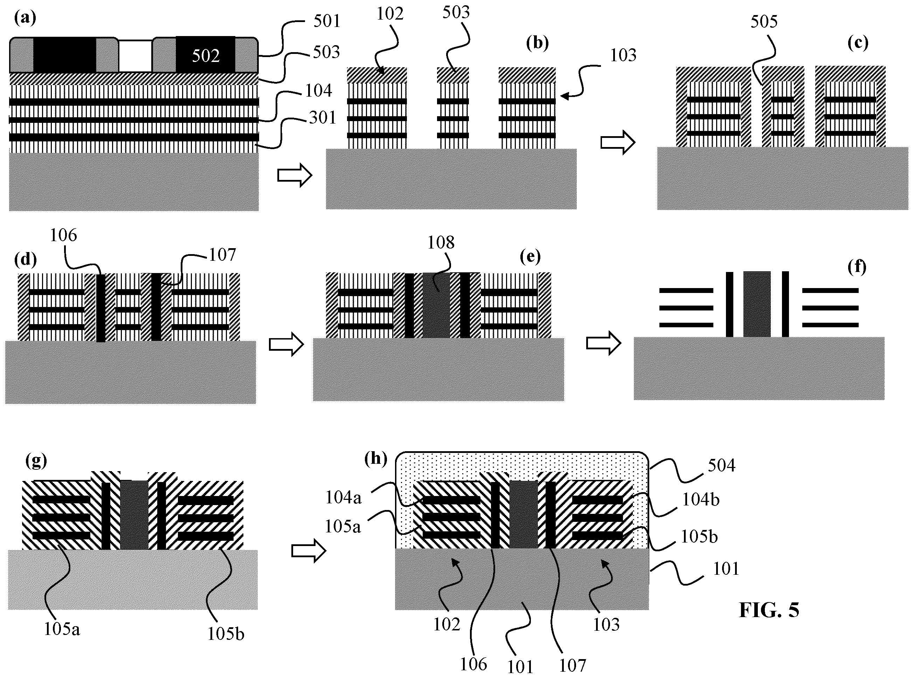

FIG. 5 shows a third exemplary process for fabricating a FET structure 100 according to this disclosure. In this case the FET structure 100 includes one additional semiconductor layer 106, 107 (e.g., fin) per layer stack 102, 103, where each additional semiconductor layer 106, 107 is not adjoining the layer stack 102, 103, besides which it is arranged. The process of FIG. 5 may thus be used to form the FET structure 100 of FIG. 2b.

In FIG. 5a, a larger layer stack comprising semiconductor channel layers 104 (e.g., silicon) and semiconductor dummy gate layers 301 (e.g., silicon germanium) is grown on a substrate layer 101 (e.g., silicon). Further a dielectric layer 503, and spacer layers 501 and 502 are arranged on top of the larger layer stack.

FIG. 5b shows that then, using the spacer layers 501 and 502, the previously grown larger layer stack is etched to obtain the narrower first layer stack 102, the second layer stack 103, respectively, and also a third layer stack arranged between the first layer stack 102 and the second layer stack 103. This can be done by any trench etching procedure.

FIG. 5c shows that then dielectric spacers 505 are formed on the sides of the three layer stacks, respectively, in particular of the first layer stack 102 and the second layer stack 103.

In FIG. 5d, the remaining free spaces between the dielectric spacers 505 are filled with semiconductor material, which forms the first additional semiconductor channel layer 106 and the second additional semiconductor channel layer 107. Afterwards planarization can be performed.

In FIG. 5e, the third layer stack located between the first layer stack 102 and the second layer stack 103 is removed, for instance, by etching. The created space is filled with a dielectric material, which forms the dielectric wall 108.

In FIG. 5f, a sacrificial release procedure is performed to remove the semiconductor dummy gate layers 301 selectively.

In FIG. 5g, the gate layers 105 are formed. In particular, as shown, gate layers 105a made from an n-type work function metal and gate layers 105b made from a p-type work function metal 105b, respectively, for the first layer stack 102 and the second layer stack 105b may be made. Notably, the one or more gate layers 105a of the first layer stack 102, and respectively the one or more gate layers 105b of the second layer stack 103 may be formed by forming them integrally with a first GAA structure and a second GAA structure. These GAA structures may be formed respectively around the first layer stack 102 and the first semiconductor channel layer 106 arranged besides the first layer stack 102, and around the second layer stack 103 and the second additional semiconductor channel layer 107 arranged besides the second layer stack 103. In this way, the first layer stack 102, the first additional semiconductor channel layer 106, and the first GAA structure may form an n-FET structure. Likewise, the second layer stack 103, the second additional semiconductor channel layer 107, and the second GAA structure may form a p-FET structure.

In FIG. 5h, a dielectric material 504 is arranged on the substrate layer 101, wherein the dielectric material 504 encloses the first layer stack 102, the second layer stack 103, each additional semiconductor channel layer 106, 107, and the dielectric wall 108, and optionally each of the GAA structures.

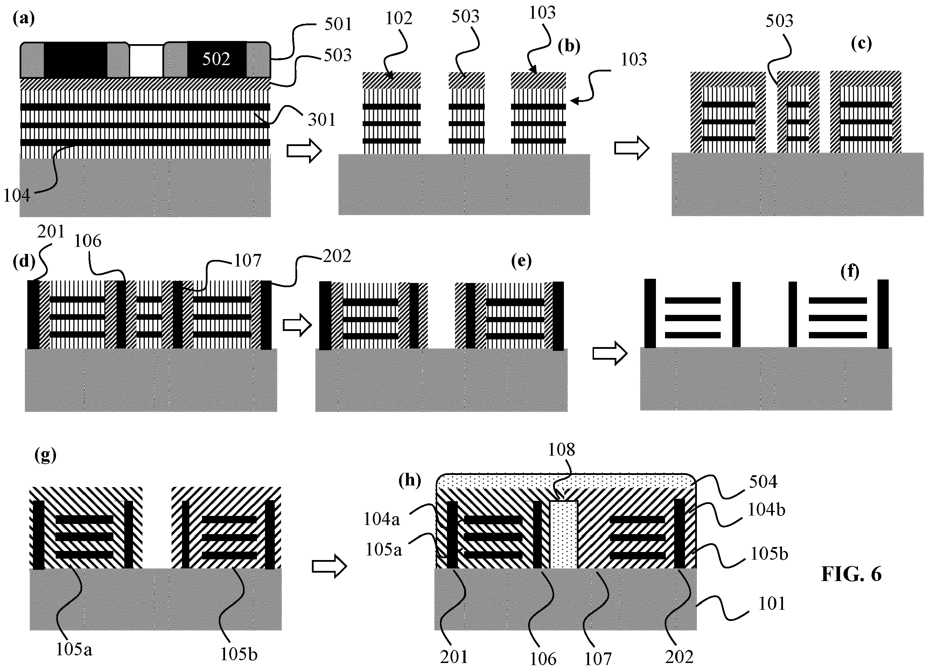

FIG. 6 shows a fourth exemplary process for fabricating a FET structure 100 according to this disclosure. In this case the FET structure 100 includes two additional semiconductor layers 106, 201, 107, 202 (e.g., fins) per layer stack 102, 103, where each additional semiconductor layer 106, 107, 201, 202 is not adjoining the layer stack 102, 103 (particularly the semiconductor channel layers 104 thereof), besides which it is arranged. The process of FIG. 6 may thus be used to form the FET structure 100 of FIG. 2d.

The process is similar to the one shown in FIG. 5. The difference is mainly that in this fourth exemplary process, the third additional semiconductor layer 201 and the fourth additional semiconductor layer 202 are additionally formed in FIG. 6D. To this end, in FIG. 6b, additional spaces are etched on the outer sides of the layer stacks 102, 103, respectively, at the locations where later the third and fourth additional semiconductor channel layers 201, 202 are formed.

The process of FIG. 6 also works, as an example, without providing the dielectric layer that forms the dielectric wall 108 (compare FIG. 5e), but instead the surrounding dielectric material 504 formed in FIG. 6h integrally forms the dielectric wall 108.

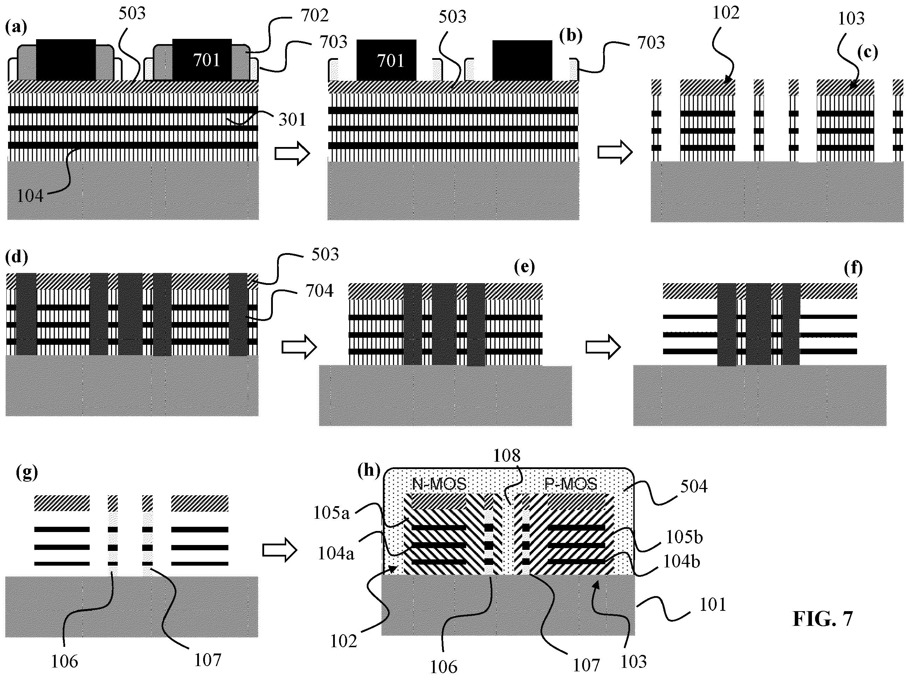

FIG. 7 shows a fifth exemplary process for fabricating a FET structure 100 according to this disclosure. In this case the FET structure 100 includes one additional semiconductor layer 106, 107 (e.g., fin) per layer stack 102, 103, wherein each additional semiconductor layer 106, 107 is not adjoining the layer stack 102, 103, besides which it is arranged, and comprises sections of different semiconductor materials. The process of FIG. 7 may thus be used to form the FET structure 100 of FIG. 2c.

In FIG. 7a, a layer stack of semiconductor channel layers 104 and semiconductor dummy gate layers 301 is formed on the substrate layer 101. Further, a dielectric layer 503 and spacer layers 701, 702, and 703 are formed on top of the layer stack.

In Fig. 7b, the spacer 702 is selectively removed, for instance, by selective etching.

In FIG. 7c, the gaps created by removing the spacer 702 are used to etch trenches into the layer stack.

In FIG. 7d, these etched trenches are filled with a dielectric material 704. Planarization may be performed afterwards.

In FIG. 7e, the outermost sides of the shown intermediate FET structure are be removed.

In FIG. 7f, the semiconductor dummy gate layers 301 (e.g., made of silicon germanium) are selectively removed in the first layer stack 102 and the second layer stack 103, for example, by selective etching.

In FIG 7g, the dielectric material 704 is selectively removed. Thereby, the first additional semiconductor layer 106 and the second additional semiconductor channel layer 107 are formed by being laid free (as fin-like structures extending along the first direction from the substrate layer 101). Notably, since the selective removal of the semiconductor dummy gate layer 301 has not been performed within these fin-like structure (in FIG. 7f), the additional semiconductor channel layers 106 and 107, respectively, comprise the different sections of the different semiconductor material (e.g., silicon like the channel layers 104, and silicon germanium like the dummy gate layers 301).

In FIG. 7h, the dielectric material 504 is filled in between the layer stacks 102 and 103, and surrounds these layer stacks 102, 103, and intrinsically forms the dielectric wall 108 between the layer stacks 102 and 103.

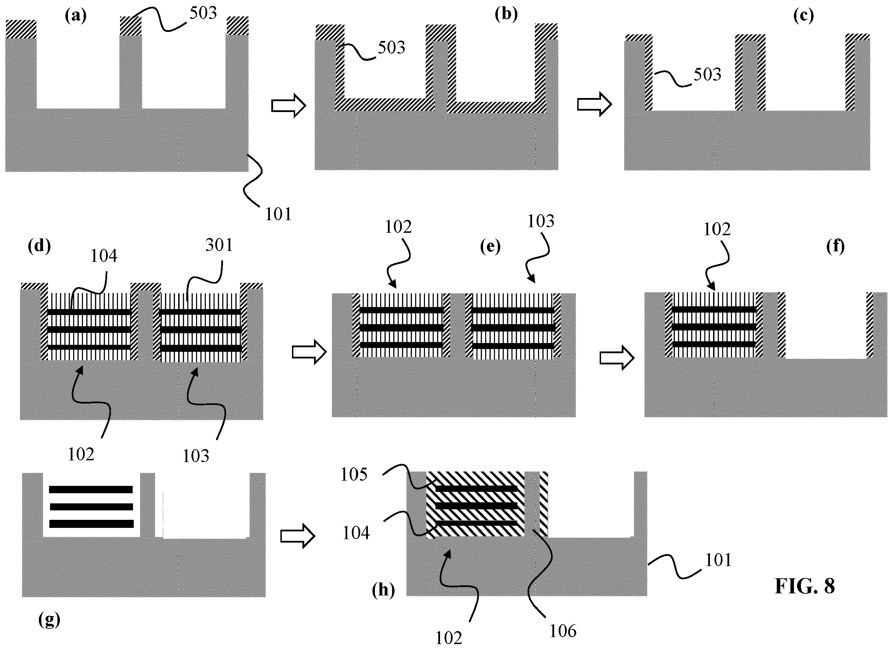

FIG. 8 shows a sixth exemplary process for fabricating a FET structure 100 according to this disclosure. In this case a FET 100 structure with only one layer stack 102 may be performed.

In FIG. 8a, a substrate layer 101 is provided with two trenches formed by using a hard mask dielectric material 503.

Then, dielectric material 503 is also formed on the sidewalls of the etched trenches in FIG. 8b. This may be done by dielectric deposition or thermal oxidation.

In FIG. 8c, the surfaces at the bottom of the trenches are freed from the dielectric material 503. For instance, by selective etching.

In FIG. 8d, the first layer stack 102 and the second layer stack 103 (at this point comprising semiconductor channel layers 104 and semiconductor dummy gate layers 301) are grown.

In FIG. 8e, planarization is performed.

In FIG. 8f, one of the layer stacks 102 and 103 can be removed, in this case the second layer stack 103.

In FGI. 8g, the remaining layer stack 102 is sacrificially etch to remove the dummy gate layers 301.

In FIG. 8h, the gate layers 104 are formed at the locations where the sacrificial etching has taken place to remove the dummy gate layers 301.

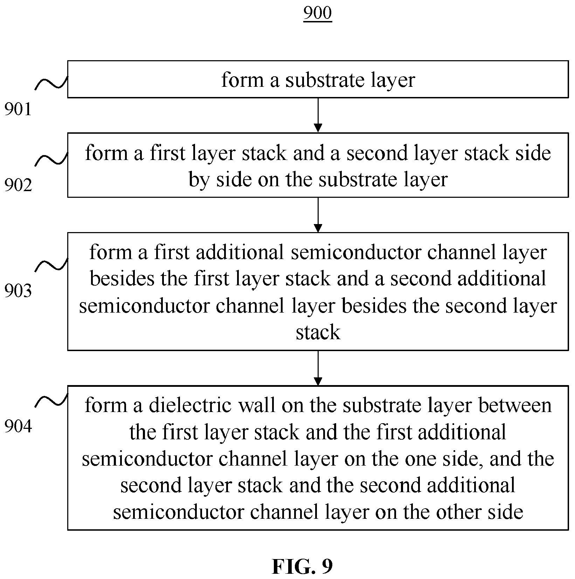

FIG. 9 shows a general method for fabricating a FET structure 100 according to this disclosure, in particular, the FET structure 100 of FIG. 1.

The method 900 comprises a step 901 of forming a substrate layer 101, and a step 902 of forming a first layer stack 102 and a second layer stack 103 side by side on the substrate layer 101. The first layer stack and the second layer stack 103 each comprise one or more semiconductor channel layers 104 and one or more gate layers 105, which are stacked in an alternating manner along a first direction perpendicular to a surface of the substrate layer 101. Further, respective surfaces of the semiconductor channel layers 104 and the gate layers 105 are parallel to the surface of the substrate layer 101.

The method 900 further comprises a step 903 of forming at least a first additional semiconductor channel layer 106 besides the first layer stack 102, and a second additional semiconductor channel layer 107 besides the second layer stack 103. Respective surfaces of the first additional semiconductor channel layer 106 and the second additional semiconductor channel layer 107 are parallel to each other and perpendicular to the surface of the substrate layer 101. The method 900 also comprises a step 904 of forming a dielectric wall 108 on the substrate layer 101 between the first layer stack 102 and the first additional semiconductor channel layer 106 on the one side of the dielectric wall 108, and the second layer stack 103 and the second additional semiconductor channel layer 107 on the other side of the dielectric wall 108.

In summary, the FET structures 100 illustrated in FIG. 1 and 2, and the exemplary process flows and methods illustrated in the FIGs. 3-9 achieve an increased effective transistor width and, accordingly, may achieve an integrated device (with the FET structure 100) that has improved device performance.

The present disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A field-effect transistor, FET, structure (100) for a nanosheet device, the FET structure (100) comprising:
a substrate layer (101);
a first layer stack (102) and a second layer stack (103) arranged side by side on the substrate layer (101),
wherein the first layer stack (102) and the second layer stack (103) each comprise one or more semiconductor channel layers (104) and one or more gate layers (105), which are stacked in an alternating manner along a first direction perpendicular to a surface of the substrate layer (101),
wherein respective surfaces of the semiconductor channel layers (104) and the gate layers (105) are parallel to the surface of the substrate layer (101);
at least a first additional semiconductor channel layer (106) arranged besides the first layer stack (102) and a second additional semiconductor channel layer (107) arranged besides the second layer stack (103),
wherein respective surfaces of the first additional semiconductor channel layer (106) and the second additional semiconductor channel layer (107) are parallel to each other and perpendicular to the surface of the substrate layer (101); and
a dielectric wall (108) arranged on the substrate layer (101) between the first layer stack (102) and the first additional semiconductor channel layer (106) on the one side, and the second layer stack (103) and the second additional semiconductor channel layer (107) on the other side.

2. The FET structure (100) according to claim 1, wherein:
the first additional semiconductor channel layer (106) adjoins the first layer stack (102); and/or
the second additional semiconductor channel layer (107) adjoins the second layer stack (103).

3. The FET structure (100) according to claim 1 or 2, further comprising:
a third additional semiconductor channel layer (201) arranged besides the first layer stack (102) on the other side of the first layer stack (102) than the first additional semiconductor channel layer (106);
a fourth additional semiconductor channel layer (202) arranged besides the second layer stack (103) on the other side of the second layer stack (103) than the second additional semiconductor channel layer (107);
wherein the dielectric wall (108) is arranged between the first layer stack (102), the first additional semiconductor channel layer (106), and the third additional semiconductor channel layer (201) on the one side, and the second layer stack (103), the second additional semiconductor channel layer (107), and the fourth additional semiconductor channel layer (202) on the other side.

4. The FET structure (100) according to claim 3, wherein:
the third additional semiconductor channel layer (201) adjoins the first layer stack (102); and/or
the fourth additional semiconductor channel layer (202) adjoins the second layer stack (103).

5. The FET structure (100) according to claim 1 or 3, wherein each additional semiconductor channel layer (106, 107, 201, 202) is distanced from the layer stack (102, 103), besides which it is arranged.

6. The FET structure (100) according to one of the claims 1 to 5, wherein:
the first layer stack (102) and the first additional semiconductor channel layer (106) form an n-FET; and/or
the second layer stack (103) and the second additional semiconductor channel layer (107) form a p-FET.

7. The FET stricture (100) according to one of the claims 1 to 6, wherein:
each additional semiconductor channel layer (106, 201) arranged besides the first layer stack (102) is made of an n-type silicon-based semiconductor material; and/or
each additional semiconductor channel layer (107, 202) arranged besides the second layer stack (103) is made of a p-type silicon-based semiconductor material.

8. The FET structure (100) according to claim 7, wherein each additional semiconductor channel layer (106, 107, 201, 202) comprises one or more sections made of silicon and one or more sections made of silicon germanium.

9. The FET structure (100) according to claim 8, wherein the one or more sections made of silicon of each additional semiconductor channel layer (106, 107, 201, 202) are respectively arranged besides the one or more semiconductor channel layers (104) of the layer stack (102, 103), besides which the additional semiconductor channel layer (106, 107, 201, 202) is arranged.

10. The FET structure (100) according to one of the claims 1 to 9, wherein:
the one or more gate layers (105, 105a) of the first layer stack (102) are made of an n-type work function metal;
the one or more gate layers (105, 105b) of the second layer stack (103) are made of a p-type work function metal.

11. The FET structure (100) according to one of the claims 1 to 10, further comprising:
a first gate all around, GAA, structure that surrounds the first layer stack (102) and each additional semiconductor channel layer (106, 201) arranged besides the first layer stack (102), wherein the one or more gate layers (105, 105a) of the first layer stack (102) are formed integral with the first GAA structure; and/or
a second GAA structure that surrounds the second layer stack (103) and each additional semiconductor channel layer (107, 202) arranged besides the second layer stack (103), wherein the one or more gate layers (105, 105b) of the second layer stack (103) are formed integral with the second GAA structure.

12. The FET structure (100) according to claim 11, further comprising:
a dielectric material arranged on the substrate layer (101) and enclosing the first layer stack (102), the second layers stack (103), each additional semiconductor channel layer (106, 107, 201, 202), each GAA structure, and the dielectric wall (108).

13. The FET structure (100) according to claim 11 or 12, wherein:
the first layer stack (102), each additional semiconductor channel layer (106, 201) arranged besides the first layer stack (102), and the first GAA structure form an n-FET structure; and
the second layer stack (103), each additional semiconductor channel layer (107, 202) arranged besides the second layer stack (107), and the second GAA structure form a p-FET structure.

14. A nanosheet device comprising the FET structure (100) according to any one of the claims 1 to 13.

15. A method (900) for fabricating a FET structure (100) for a nanosheet device, the method (900) comprising:
forming (901) a substrate layer (101);
forming (902) a first layer stack (102) and a second layer stack (103) side by side on the substrate layer (101);
wherein the first layer stack (102) and the second layer stack (103) each comprise one or more semiconductor channel layers (104) and one or more gate layers (105), which are stacked in an alternating manner along a first direction perpendicular to a surface of the substrate layer (101);
wherein respective surfaces of the semiconductor channel layers (104) and the gate layers (105) are parallel to the surface of the substrate layer (101);
forming (903) at least a first additional semiconductor channel layer (106) besides the first layer stack (102) and a second additional semiconductor channel layer (107) besides the second layer stack (103),
wherein respective surfaces of the first additional semiconductor channel layer (106) and the second additional semiconductor channel layer (107) are parallel to each other and perpendicular to the surface of the substrate layer (101); and
forming (904) a dielectric wall (108) on the substrate layer (101) between the first layer stack (102) and the first additional semiconductor channel layer (106) on the one side and the second layer stack (103) and the second additional semiconductor channel layer (107) on the other side.

## Amended claims

### Amended claims in accordance with Rule 137(2) EPC.

1. A field-effect transistor, FET, structure (100) for a nanosheet device, the FET structure (100) comprising:
a substrate layer (101);
a first layer stack (102) and a second layer stack (103) arranged side by side on the substrate layer (101),
wherein the first layer stack (102) and the second layer stack (103) each comprise one or more semiconductor channel layers (104) and one or more gate layers (105), which are stacked in an alternating manner along a first direction perpendicular to a surface of the substrate layer (101),
wherein respective surfaces of the semiconductor channel layers (104) and the gate layers (105) are parallel to the surface of the substrate layer (101);
at least a first additional semiconductor channel layer (106) arranged besides the first layer stack (102) and a second additional semiconductor channel layer (107) arranged besides the second layer stack (103),
wherein the first additional semiconductor channel layer (106) and the second additional semiconductor channel layer (107) are respectively fin-like structures that extend along the first direction,
wherein each additional semiconductor channel layer (106, 107, 201, 202) is distanced from the layer stack (102, 103), besides which it is arranged, and
wherein respective surfaces of the first additional semiconductor channel layer (106) and the second additional semiconductor channel layer (107) are parallel to each other and perpendicular to the surface of the substrate layer (101); and
a dielectric wall (108) arranged on the substrate layer (101) between the first layer stack (102) and the first additional semiconductor channel layer (106) on the one side, and the second layer stack (103) and the second additional semiconductor channel layer (107) on the other side.

2. The FET structure (100) according to claim 1, further comprising:
a third additional semiconductor channel layer (201) arranged besides the first layer stack (102) on the other side of the first layer stack (102) than the first additional semiconductor channel layer (106);
a fourth additional semiconductor channel layer (202) arranged besides the second layer stack (103) on the other side of the second layer stack (103) than the second additional semiconductor channel layer (107);
wherein the dielectric wall (108) is arranged between the first layer stack (102), the first additional semiconductor channel layer (106), and the third additional semiconductor channel layer (201) on the one side, and the second layer stack (103), the second additional semiconductor channel layer (107), and the fourth additional semiconductor channel layer (202) on the other side.

3. The FET structure (100) according to claims 1 or 2, wherein:
the first layer stack (102) and the first additional semiconductor channel layer (106) form an n-FET; and/or
the second layer stack (103) and the second additional semiconductor channel layer (107) form a p-FET.

4. The FET stricture (100) according to one of the claims 1 to 3, wherein:
each additional semiconductor channel layer (106, 201) arranged besides the first layer stack (102) is made of an n-type silicon-based semiconductor material; and/or
each additional semiconductor channel layer (107, 202) arranged besides the second layer stack (103) is made of a p-type silicon-based semiconductor material.

5. The FET structure (100) according to claim 4, wherein each additional semiconductor channel layer (106, 107, 201, 202) comprises one or more sections made of silicon and one or more sections made of silicon germanium.

6. The FET structure (100) according to claim 5, wherein the one or more sections made of silicon of each additional semiconductor channel layer (106, 107, 201, 202) are respectively arranged besides the one or more semiconductor channel layers (104) of the layer stack (102, 103), besides which the additional semiconductor channel layer (106, 107, 201, 202) is arranged.

7. The FET structure (100) according to one of the claims 1 to 6, wherein:
the one or more gate layers (105, 105a) of the first layer stack (102) are made of an n-type work function metal;
the one or more gate layers (105, 105b) of the second layer stack (103) are made of a p-type work function metal.

8. The FET structure (100) according to one of the claims 1 to 7, further comprising:
a first gate all around, GAA, structure that surrounds the first layer stack (102) and each additional semiconductor channel layer (106, 201) arranged besides the first layer stack (102), wherein the one or more gate layers (105, 105a) of the first layer stack (102) are formed integral with the first GAA structure; and/or
a second GAA structure that surrounds the second layer stack (103) and each additional semiconductor channel layer (107, 202) arranged besides the second layer stack (103), wherein the one or more gate layers (105, 105b) of the second layer stack (103) are formed integral with the second GAA structure.

9. The FET structure (100) according to claim 8, further comprising:
a dielectric material arranged on the substrate layer (101) and enclosing the first layer stack (102), the second layers stack (103), each additional semiconductor channel layer (106, 107, 201, 202), each GAA structure, and the dielectric wall (108).

10. The FET structure (100) according to claim 8 or 9, wherein:
the first layer stack (102), each additional semiconductor channel layer (106, 201) arranged besides the first layer stack (102), and the first GAA structure form an n-FET structure; and
the second layer stack (103), each additional semiconductor channel layer (107, 202) arranged besides the second layer stack (107), and the second GAA structure form a p-FET structure.

11. A nanosheet device comprising the FET structure (100) according to any one of the claims 1 to 10.

12. A method (900) for fabricating a FET structure (100) for a nanosheet device, the method (900) comprising:
forming (901) a substrate layer (101);
forming (902) a first layer stack (102) and a second layer stack (103) side by side on the substrate layer (101);
wherein the first layer stack (102) and the second layer stack (103) each comprise one or more semiconductor channel layers (104) and one or more gate layers (105), which are stacked in an alternating manner along a first direction perpendicular to a surface of the substrate layer (101);
wherein respective surfaces of the semiconductor channel layers (104) and the gate layers (105) are parallel to the surface of the substrate layer (101);
forming (903) at least a first additional semiconductor channel layer (106) besides the first layer stack (102) and a second additional semiconductor channel layer (107) besides the second layer stack (103),
wherein the first additional semiconductor channel layer (106) and the second additional semiconductor channel layer (107) are respectively fin-like structures that extend along the first direction,
wherein each additional semiconductor channel layer (106, 107, 201, 202) is distanced from the layer stack (102, 103), besides which it is arranged, and
wherein respective surfaces of the first additional semiconductor channel layer (106) and the second additional semiconductor channel layer (107) are parallel to each other and perpendicular to the surface of the substrate layer (101); and
forming (904) a dielectric wall (108) on the substrate layer (101) between the first layer stack (102) and the first additional semiconductor channel layer (106) on the one side and the second layer stack (103) and the second additional semiconductor channel layer (107) on the other side.
